(19) Europäisches Patentamt / European Patent Office / Office européen des brevets

(11) **EP 2 793 399 B1**

(12) **FASCICULE DE BREVET EUROPEEN**

(45) Date de publication et mention
de la délivrance du brevet:
**29.07.2015 Bulletin 2015/31**

(51) Int Cl.:
*H03L 7/02* (2006.01)     *G01G 3/16* (2006.01)

(21) Numéro de dépôt: **14164290.0**

(22) Date de dépôt: **10.04.2014**

(54) **Circuit de mesure de fréquence de résonance de nano-résonateurs**

Schaltkreis zum Messen der Resonanzfrequenz von Nanoresonatoren

Circuit for measuring the resonance frequency of nanoresonators

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **17.04.2013 FR 1353464**

(43) Date de publication de la demande:
**22.10.2014 Bulletin 2014/43**

(73) Titulaire: **COMMISSARIAT A L'ENERGIE
ATOMIQUE ET AUX
ENERGIES ALTERNATIVES
75015 Paris (FR)**

(72) Inventeurs:
 • **Villard, Patrick
  38000 GRENOBLE (FR)**
 • **Billiot, Gérard
  38330 ST NAZAIRE LES EYMES (FR)**

(74) Mandataire: **Guérin, Michel et al
Marks & Clerk France
Conseils en Propriété Industrielle
Immeuble Visium
22, Avenue Aristide Briand
94117 Arcueil Cedex (FR)**

(56) Documents cités:
**WO-A2-02/090246     US-A1- 2011 254 599**

 • **CHADY KHARRAT ET AL: "Hâ Loop shaping
control for PLL-based mechanical resonance
tracking in NEMS resonant mass sensors", 2008
IEEE SENSORS,LECCE, ITALY, IEEE,
PISCATAWAY, NJ, USA, 26 octobre 2008
(2008-10-26), pages 1135-1138, XP031375279,
ISBN: 978-1-4244-2580-8**

EP 2 793 399 B1

**Description**

L'invention concerne les circuits à résonateurs électro-mécaniques micro-usinés et en particulier les oscillateurs à nanorésonateurs ou oscillateurs NEMS (de l'anglais "nanoelectromechanical systems", c'est-à-dire systèmes nano-électromécaniques). Ces systèmes intègrent sur un substrat des éléments mécaniques, micro-usinés à l'échelle du nanomètre par des technologies de fabrication collective de la microélectronique.

Ces circuits peuvent être utilisés notamment pour la mesure de masses très faibles, typiquement comprises entre $10^{-24}$ et $10^{-21}$ grammes. Les applications visées sont par exemple l'analyse de gaz ou la spectrométrie de masse.

Dans de tels systèmes utilisant des résonateurs, le signal à mesurer est la fréquence de résonance du nano-résonateur, celle-ci dépendant en effet directement de la masse de matière déposée sur le résonateur ou adsorbée à sa surface, une masse plus importante engendrant une fréquence de résonance plus basse.

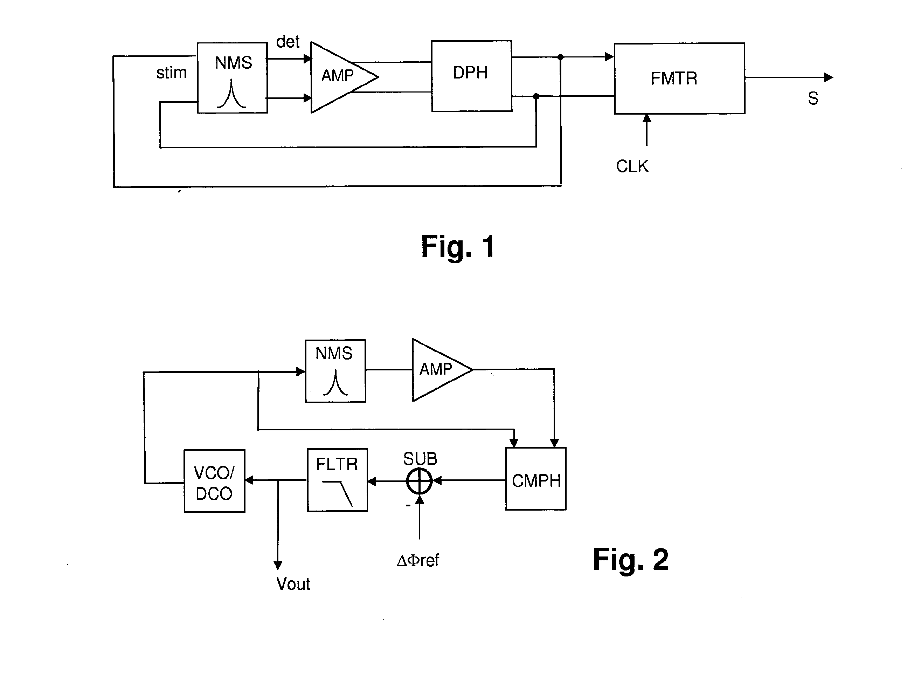

Pour mesurer la fréquence de résonance, on a déjà proposé d'utiliser un circuit auto-oscillant comprenant une boucle d'oscillation fermée incorporant le résonateur. La figure 1 représente schématiquement un tel circuit auto-oscillant. La boucle auto-oscillante comprend le résonateur NMS en série avec une chaîne d'amplification et de déphasage, et une contre-réaction entre la sortie de la chaîne et une entrée d'excitation du résonateur. La chaîne d'amplification apporte un gain par un amplificateur AMP et un déphasage par un déphaseur DPH ; elle permet d'assurer des conditions d'oscillation naturelle (gain de boucle ouverte supérieur ou égal en module à 1 pour un déphasage de boucle multiple de $2\pi$). La fréquence d'oscillation est la fréquence de résonance mécanique naturelle du résonateur NMS. Elle est mesurée à la sortie de la chaîne d'amplification par un fréquencemètre FMTR. Ce dernier peut fonctionner par exemple sur le principe d'un comptage d'impulsions d'une horloge de référence CLK ayant une fréquence très supérieure à la fréquence d'oscillation. La sortie analogique ou numérique S du fréquencemètre fournit une mesure de la fréquence de résonance propre du résonateur. Cette solution permet de réaliser des circuits peu encombrants, ce qui est important notamment dans le cas où on souhaite réaliser un réseau comportant un grand nombre de nanorésonateurs. Mais, comme il y a une grande dispersion technologique des résonateurs et des composants de la chaîne d'amplification, il est difficile de garantir a priori l'obtention des conditions de gain et de phase qui permettent une oscillation naturelle spontanée à la fréquence de résonance.

On a également proposé des circuits à boucle d'asservissement de phase (boucle PLL), tel que celui qui est représenté schématiquement sur la figure 2. Le circuit comprend encore un nano-résonateur NMS en série avec un amplificateur AMP, un oscillateur contrôlé en tension (VCO) ou un oscillateur contrôlé numériquement (DCO) pour exciter le résonateur (NMS), un comparateur de phase CMPH, et un soustracteur SUB pour soustraire à la sortie du comparateur de phase une valeur (modulo $2\pi$) qui représente le déphasage naturel $\Delta\Phi$ref introduit par le résonateur et l'amplificateur à la fréquence de résonance. Un filtre passe-bas FLTR est interposé entre la sortie du comparateur de phase et une entrée de commande de l'oscillateur pour assurer la stabilité de la boucle d'asservissement.

La valeur $\Delta\Phi$ref est une valeur de déphasage mesurée par calibration en faisant fonctionner le résonateur et l'amplificateur en boucle ouverte à la fréquence de résonance et en observant le déphasage entre le signal d'excitation du résonateur et la sortie de l'amplificateur.

Le circuit s'asservit automatiquement sur la fréquence pour laquelle le déphasage entre les entrées du comparateur de phase est égal à $\Delta\Phi$ref ; cette fréquence est la fréquence de résonance naturelle du résonateur. En effet, en boucle fermée, la sortie du comparateur de phase représente le déphasage du résonateur et de l'amplificateur. S'il n'est pas égal à $\Delta\Phi$ref, la tension de commande de l'oscillateur VCO s'ajuste jusqu'à ce qu'il devienne égal à $\Delta\Phi$ref, déphasage correspondant à la résonance. La mesure de la fréquence de résonance se fait ensuite par la mesure de la tension de commande Vout de l'oscillateur, cette tension représentant la fréquence d'oscillation de l'oscillateur. Cette solution à boucle PLL nécessite une calibration préalable pour connaître le déphasage $\Delta\Phi$ref à la résonance afin que l'accrochage de la boucle corresponde bien à la fréquence de résonance.

Lorsque le résonateur NEMS est un résonateur à actionnement électrostatique et détection par jauges piézorésistives, il comprend deux électrodes d'actionnement qui reçoivent un signal à fréquence d'actionnement f0 proche de la fréquence de résonance. On a déjà proposé que les jauges de détection soient alimentées par un signal de polarisation dynamique Vbias comportant une composante alternative à fréquence f1. L'élément vibrant du résonateur, par exemple une poutre vibrante, vibre à la fréquence f0 et les jauges piézorésistives fournissent un signal de détection à la fréquence f0 mais ce signal comporte une composante de modulation à la fréquence f1 due à la polarisation, ce qui fait que le signal de sortie des jauges comprend une composante à une fréquence f0-f1 et une composante à la fréquence f0+f1. L'une peut être éliminée par filtrage et l'autre porte une information de déphasage introduit par le résonateur, déphasage qui sert à l'asservissement.

La publication de brevet WO2005/081929 décrit une réalisation sur ce principe, avec une génération des signaux à fréquence f0 et f1 par des sources indépendantes. Une fréquence différence f0-f1 est obtenue par mélange et est utilisée comme référence pour détecter la modulation du signal de sortie du résonateur, signal qui comprend justement une composante à fréquence f0-f1. La corrélation qui existe entre la fréquence f0-f1 produite dans le résonateur et la fréquence de référence f0-f1 permet une mesure avec un faible bruit de phase. Toutefois, la réalisation décrite est difficile à mettre en oeuvre car elle nécessite deux synthétiseurs de fréquence pour établir les fréquences f0 et f1, et ces deux synthétiseurs doivent être réglables en fréquence avec une résolution élevée, l'un parce qu'il assure l'asservissement de l'excitation du résonateur, l'autre parce qu'il doit être ajusté si on veut que la détection synchrone en sortie du résonateur se fasse à fréquence constante. Il en résulte un encombrement en surface de circuit intégré et un coût correspondant, et en outre une consommation d'énergie importante.

La publication de brevet US 2011/254599 A1 décrit un circuit de mesure de la fréquence d'oscillation d'un résonateur (NMS) utilisant une boucle d'asservissement de phase.

Un but de l'invention est de proposer un circuit à résonateur réduisant les ressources nécessaires en énergie et consommation, tout en conservant un faible bruit de phase.

Selon l'invention, on propose un circuit de mesure de fréquence d'oscillation d'un résonateur du type comportant une entrée d'excitation pour

recevoir un signal d'actionnement à une fréquence proche de la fréquence de résonance du résonateur et une entrée de polarisation pour recevoir un signal de polarisation comprenant une composante alternative à une fréquence de polarisation f1, le circuit comportant une boucle d'asservissement de phase comprenant le résonateur, un oscillateur à fréquence contrôlée, et un comparateur de phase, le circuit de mesure étant caractérisé en ce que l'oscillateur à fréquence contrôlée produit la fréquence de polarisation f1 et est relié à l'entrée de polarisation du résonateur pour lui appliquer cette fréquence f1, et en ce qu'il comprend en outre un générateur de fréquence fournissant une fréquence intermédiaire fixe FI, un mélangeur pour mélanger la fréquence intermédiaire et la fréquence de polarisation f1 pour établir une fréquence d'excitation f0 somme ou différence de f1 et FI et appliquer cette fréquence d'excitation f0 à l'entrée d'excitation en tant que signal d'actionnement, le comparateur de phase recevant la fréquence intermédiaire FI du générateur et un signal de sortie filtré issu du résonateur et fournissant un signal d'asservissement servant à commander la fréquence f1 de l'oscillateur dans un sens tendant à maintenir la fréquence d'excitation en sortie du mélangeur à la valeur de la fréquence de résonance du résonateur.

La sortie du mélangeur peut être appliquée directement à l'entrée d'excitation du résonateur, sans filtrage passe-bande préalable, le résonateur assurant lui-même, par sa constitution physique, le filtrage passe-bande éliminant une seule des deux composantes de fréquence FI-f1 ou FI+f1 présentes en sortie du mélangeur.

Par conséquent, l'oscillateur à fréquence contrôlée de la boucle d'asservissement de phase ne fonctionne pas à la fréquence d'excitation f0 comme c'est usuel mais à la fréquence de polarisation f1. La boucle d'asservissement de phase comprend, outre le résonateur, l'oscillateur à fréquence contrôlée et le comparateur de phase, un mélangeur qui produit la fréquence d'excitation à partir de la fréquence intermédiaire et de la sortie de l'oscillateur à fréquence contrôlée.

La fréquence intermédiaire FI est fixe : elle peut être paramétrable pour pouvoir être ajustée en fonction des caractéristiques du résonateur, mais elle ne varie pas en raison de l'asservissement.

Par l'appellation "oscillateur à fréquence contrôlée", on entend aussi bien des oscillateurs analogiques, contrôlés par une tension ou par une entrée numérique, que des synthétiseurs de fréquence numérique directe fournissant un signal sinusoïdal de phase et de fréquence contrôlées.

Le générateur de fréquence qui produit la fréquence intermédiaire FI peut fournir un signal sinusoïdal à fréquence FI, ce qui est favorable à la pureté spectrale des signaux engendrés par le mélangeur et des signaux produits par le résonateur. Dans ce cas on le réalisera de préférence sous forme d'un synthétiseur numérique direct de fréquence, comprenant un convertisseur numérique-analogique de sortie. Mais on peut envisager aussi que le générateur de fréquence fournisse des signaux carrés. C'est moins favorable du point de vue de la pureté spectrale puisqu'un signal carré comporte de nombreux harmoniques, mais c'est beaucoup plus simple à réaliser. On peut en effet utiliser comme générateur de fréquence un simple circuit d'horloge.

Que le générateur fournisse des signaux carrés ou des signaux sinusoïdaux, on peut prévoir qu'il fournit deux signaux en quadrature de phase (I et Q). Le comparateur de phase reçoit les signaux du générateur à fréquence intermédiaire et travaille aussi sur deux voies en quadrature de phase. Il établit deux signaux représentant les différences de phase constatées sur les deux voies, entre la phase en sortie du résonateur et la phase I ou Q du générateur de fréquence FI. Ces deux signaux sont convertis en un signal de valeur de déphasage dont l'amplitude représente le déphasage constaté, signal qui sert à la commande de l'oscillateur à fréquence contrôlée. Si le générateur de fréquence intermédiaire FI est réalisé sous forme d'un circuit d'horloge fournissant des signaux carrés, on remarquera qu'il est très facile de produire deux signaux en quadrature de phase en partant d'une horloge de base de fréquence quatre fois égale à FI.

L'oscillateur à fréquence contrôlée peut, lui aussi, fournir des signaux en quadrature de phase. Le mélangeur présent dans la boucle d'asservissement est alors un mélangeur complexe mélangeant les deux voies de l'oscillateur à fréquence contrôlée et les deux voies du générateur de fréquence intermédiaire. De préférence, le mélangeur est utilisé en mélangeur complexe dans une phase de calibration en boucle ouverte, c'est-à-dire qu'il mélange les signaux de voies I et Q, mais il est utilisé comme un mélangeur simple dans une phase d'utilisation de la boucle fermée. La calibration a pour but de déterminer le déphasage naturel introduit par le résonateur à la résonance ; elle consiste à rechercher la résonance par une mesure du gain en boucle ouverte à une fréquence variable, et à mesurer le déphasage produit par la boucle à la fréquence de résonance (le déphasage introduit par le résonateur varie beaucoup à proximité de la résonance). Le déphasage à la résonance est ensuite introduit en tant que consigne dans la boucle d'asservissement fermée.

Par ailleurs, on peut prévoir que la fréquence de polarisation f1 est obtenue par le mélange d'une fréquence fixe f2 (paramétrable en fonction du type de résonateur) et d'une fréquence asservie variable f'1 ; en d'autres mots, l'oscillateur à fréquence contrôlée qui produit la fréquence f1 comprend des moyens analogiques ou numériques (oscillateur à fréquence contrôlée ou synthétiseur de fréquence) pour établir une fréquence f'1 variable sous contrôle de la boucle d'asservissement de phase, et un mélangeur pour mélanger cette fréquence f'1 à une fréquence fixe f2 et ainsi produire la fréquence de polarisation variable f1 (égale à f2+f'1 ou f2-f'1). L'ajustement de la fréquence f1 se fait alors seulement par ajustement de la fréquence f'1, laquelle peut être beaucoup plus faible que f1.

La comparaison de phase se fait de préférence par un circuit entièrement numérique, un convertisseur analogique-numérique étant alors placé en sortie du résonateur ou de préférence en sortie d'un filtre passe-bas qui suit le résonateur. Cependant, la comparaison de phase pourrait également se faire en analogique.

D'autres caractéristiques et avantages de l'invention apparaîtront à la lecture de la description détaillée qui suit et qui est faite en référence aux dessins annexés dans lesquels :

- la figure 1, déjà décrite, représente un circuit de mesure auto-oscillant à nano-résonateur ;
- la figure 2, déjà décrite, représente un circuit de mesure oscillant à nano-résonateur, comportant une boucle d'asservissement de phase ;
- la figure 3 représente symboliquement un nano-résonateur à détection par jauges résistives ;
- la figure 4 représente un circuit de mesure à boucle d'asservissement de phase dans une version simple selon l'invention ;
- la figure 5 représente une réalisation dans laquelle la fréquence d'excitation du résonateur est produite à partir d'un signal à fréquence intermédiaire carré ;
- la figure 6 représente un circuit de mesure dans lequel le comparateur de phase est numérique ;
- la figure 7 représente un circuit de mesure dans lequel le comparateur de phase travaille sur deux voies en quadrature de phase ;
- la figure 8 représente un circuit de mesure dans lequel la fréquence de polarisation est produite sur deux voies en quadrature de phase pour être mélangée à la fréquence intermédiaire également produite sur deux voies en quadrature de phase ;
- la figure 9 représente la constitution et les équations régissant un mélangeur simple et un mélangeur complexe ;
- la figure 10 représente un circuit de mesure dans lequel la fréquence de polarisation est elle-même produite par mélange d'une fréquence fixe (paramétrable) et d'une fréquence contrôlée par la boucle d'asservissement.

Le nano-résonateur utilisé dans le circuit de mesure selon l'invention est du type suivant, quelle que soit sa réalisation pratique : il possède une entrée d'excitation de la vibration pour recevoir un signal d'actionnement à une fréquence d'excitation (f0), une entrée de polarisation pour recevoir un signal de polarisation ayant une composante alternative à une fréquence de polarisation (f1), et enfin une sortie pour fournir un signal électrique représentant la vibration du nano-résonateur. La fréquence de polarisation sert à moduler le signal de sortie pour faciliter la mesure. Le signal de sortie, modulé par le signal de polarisation, comprend une composante à une fréquence intermédiaire qui est la différence de la fréquence d'excitation et de la fréquence de polarisation, ainsi qu'une composante à une fréquence qui est la somme de ces deux fréquences. C'est à ce type de nano-résonateur que s'applique de manière générale la présente invention. La composante à fréquence somme sera éliminée par filtrage. La composante à fréquence intermédiaire contient une information de phase qui sera exploitée dans une boucle d'asservissement de phase.

Dans un exemple auquel on se référera dans la suite, le nano-résonateur micro-usiné est un résonateur à actionnement électrostatique et à détection piézorésistive, c'est-à-dire en pratique une détection par jauges de contrainte. Des résonateurs de ce type sont décrits par exemple dans le brevet français FR2964651. Ils comprennent par exemple une poutre vibrante suspendue par un ou plusieurs bras de flexion ; la vibration de la poutre est excitée et entretenue par les forces électrostatiques engendrées par des électrodes recevant un signal électrique d'actionnement alternatif à une fréquence proche de la fréquence de résonance mécanique de la poutre ; des jauges de contrainte, de préférence des jauges piézorésistives, sont placées sur la poutre ou sur les bras de flexion ou sur tout élément mécanique lié à la poutre et réagissant aux mouvements de celle-ci ; elles servent à détecter le mouvement de la poutre par l'intermédiaire de la détection des contraintes qui s'exercent sur elles lors de la vibration de la poutre. Les jauges de contraintes reçoivent le signal de polarisation et fournissent le signal de sortie du nano-résonateur.

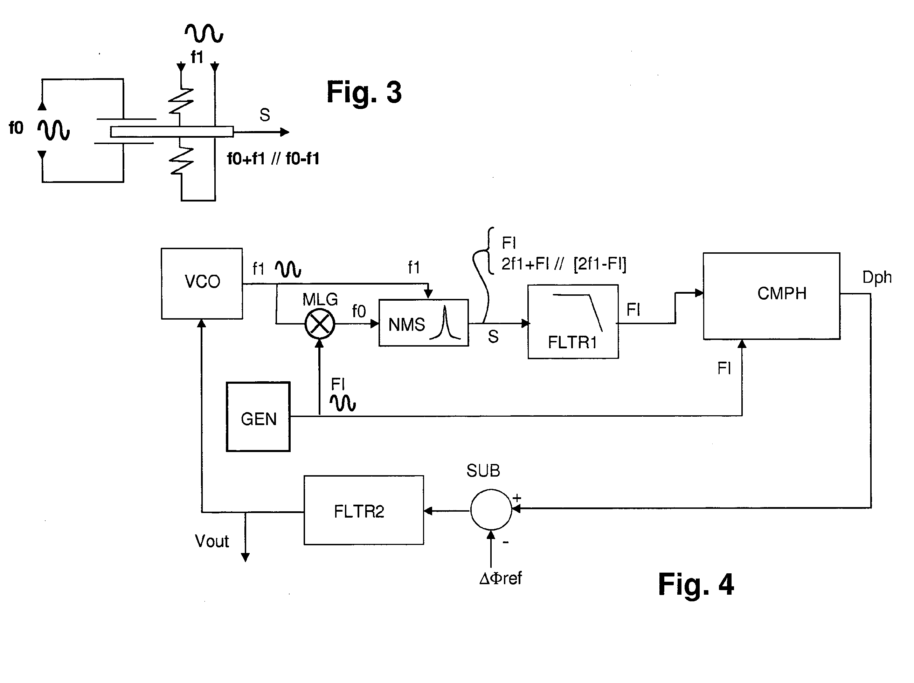

La figure 3 représente symboliquement le nano-résonateur avec son entrée d'excitation à une fréquence f0, reliée à des électrodes d'actionnement qui excitent la vibration de la poutre, son entrée de polarisation à fréquence f1, reliée aux jauges de contrainte, et sa sortie S également reliée aux jauges de contrainte. Les jauges de contrainte sont représentées comme des résistances.

Le circuit de mesure de la fréquence de résonance du nano-résonateur NMS est représenté à la figure 4. Il utilise un oscillateur à fréquence contrôlée VCO qui produit un signal sinusoïdal à une fréquence de polarisation f1, et non un signal à la fréquence d'excitation f0 comme c'est le cas dans l'art antérieur. Ce signal est appliqué à l'entrée de polarisation du nano-résonateur. La fréquence de polarisation f1 est donc maintenant une fréquence variable en fonction de l'asservissement. L'oscillateur VCO peut être un oscillateur analogique contrôlé par une tension ou par une entrée numérique, ou un synthétiseur de fréquence numérique directe à fréquence contrôlée.

Selon l'invention, on prévoit un générateur de fréquence à fréquence fixe GEN qui produit une fréquence intermédiaire FI qui est une fréquence de référence et non une fréquence dépendant de l'asservissement de phase. Un générateur à fréquence fixe est significativement plus simple à réaliser qu'un générateur à fréquence commandable. Dans l'exemple de la figure 4, le générateur produit un signal sinusoïdal, mais on verra qu'il peut produire un signal carré. Un mélangeur MLG reçoit la fréquence fixe FI de ce générateur ainsi que la fréquence de sortie f1 de l'oscillateur VCO. La sortie du mélangeur contient une composante à fréquence somme f1+ FI et une composante à fréquence différence f1-FI.

L'une des composantes peut être éliminée d'une manière naturelle car le nano-résonateur est à bande passante très étroite par nature ; la fréquence FI est choisie de préférence plus grande que la largeur de bande du résonateur de manière que l'une des fréquences FI+f1 et f1-FI tombe dans la bande passante du résonateur mais pas l'autre. Par exemple, c'est la composante à fréquence différence f1-FI qui est en dehors de la bande du résonateur et la fréquence f1+FI qui est dans la bande du résonateur. Dans ce qui suit on considère que c'est la fréquence f1 + FI qui est dans la bande du résonateur et qui devient la fréquence d'excitation du résonateur, qui s'asservit sur la fréquence de résonance propre f0 du résonateur grâce à la boucle d'asservissement de phase. La fréquence f1-FI est alors naturellement éliminée par le résonateur lui-même.

Le nano-résonateur excité par la fréquence f1 + FI et polarisé par la fréquence f1 fournit à sa sortie un signal modulé ayant une composante à fréquence FI et une composante à fréquence 2f1+FI. Cette dernière est éliminée par un filtrage passe-bas dans un filtre FLTR1. Le filtre FLTR1 peut comprendre un amplificateur à faible bruit si c'est nécessaire. La composante à fréquence FI comporte une information de phase, le déphasage introduit par le résonateur étant très variable en fonction de l'écart entre la fréquence d'excitation f1+FI et la fréquence propre de résonance f0 du résonateur. Cette information de phase est détectée dans un comparateur de phase CMPH qui reçoit d'une part la fréquence intermédiaire fixe FI originale issue du générateur GEN et d'autre part la sortie du filtre FLTR1.

Le comparateur de phase CMPH fournit un signal en bande de base, qui représente une valeur de déphasage Dph entre la fréquence FI fournie par le générateur et la fréquence FI issue du filtre FLTR1. Cette valeur de déphasage est la variable à partir de laquelle l'oscillateur VCO va être asservi pour ramener cette variable à une valeur de consigne correspondant à la résonance. L'asservissement ajuste la fréquence du signal f1 de manière que le signal d'excitation à fréquence FI+f1 ait lui-même la fréquence correspondant exactement à la résonance du nano-résonateur. Le déphasage de boucle et la fréquence de résonance sont déterminés par calibration en boucle ouverte et permettent de définir une consigne de phase à respecter pour être sûr d'être en situation de résonance. En boucle fermée, la consigne est appliquée sous forme d'une valeur de déphasage $\Delta\Phi$ref à une entrée d'un soustracteur SUB qui reçoit par ailleurs la valeur du déphasage Dph déterminé par le comparateur de phase. La sortie du soustracteur est filtrée par un filtre FTLR2 en fonction des fonctions de filtrage plus ou moins sophistiquées qu'on souhaite donner à l'asservissement pour assurer sa stabilité ; la sortie filtrée est appliquée comme signal de commande Vout à l'oscillateur contrôlé VCO. Le signal de commande Vout est en même temps la sortie du circuit de mesure : il représente directement la valeur de la fréquence de résonance du nano-résonateur lorsque la boucle d'asservissement fonctionne. La sortie est analogique ou numérique selon la constitution de la boucle.

Dans ce qui précède, la fréquence de sortie FI du générateur est fixe. Cependant, la fréquence fixe peut être paramétrable, c'est-à-dire qu'on peut choisir une fréquence fixe ou une autre selon le résonateur ou le type de résonateur utilisé.

Pour donner des exemples de fréquences, le nano-résonateur peut avoir une fréquence de résonance de 10 à 100 MHz, avec une bande passante de quelques kilohertz à quelques dizaines de kilohertz. La fréquence intermédiaire peut être de l'ordre de 20 à 100 kilohertz, la condition préférée étant que la fréquence somme f1+FI et la fréquence différence f1-FI ne tombent pas toutes les deux dans la bande passante du résonateur.

De manière générale, il faut considérer que le nano-résonateur reçoit un signal analogique sinusoïdal sur son entrée de polarisation et qu'il fournit un signal analogique sur sa sortie. Le filtre FTLR1 qui le suit peut être analogique. Tout le reste de la boucle d'asservissement de phase peut-être soit numérique, soit analogique, soit mixte. Lorsque le comparateur de phase est numérique, il faut un convertisseur analogique-numérique entre la sortie du résonateur et l'entrée du comparateur de phase. Ce convertisseur est de préférence placé en sortie du filtre FLTR1. Le filtre FLTR1 peut comprendre un amplificateur à faible bruit non représenté, qui amplifie le signal issu du résonateur avant de le filtrer.

L'oscillateur à fréquence contrôlée VCO peut avoir une commande analogique ou numérique ; il peut être réalisé sous forme purement analogique (oscillateur à fréquence contrôlée par une tension) ou sous forme partiellement numérique (oscillateur analogique à fréquence contrôlée par une donnée numérique) ou presque totalement numérique (synthétiseur de fréquence à commande numérique suivi d'un convertisseur numérique analogique fournissant une forme d'onde la plus sinusoïdale possible). Les figures qui suivent donnent des exemples de ces possibilités.

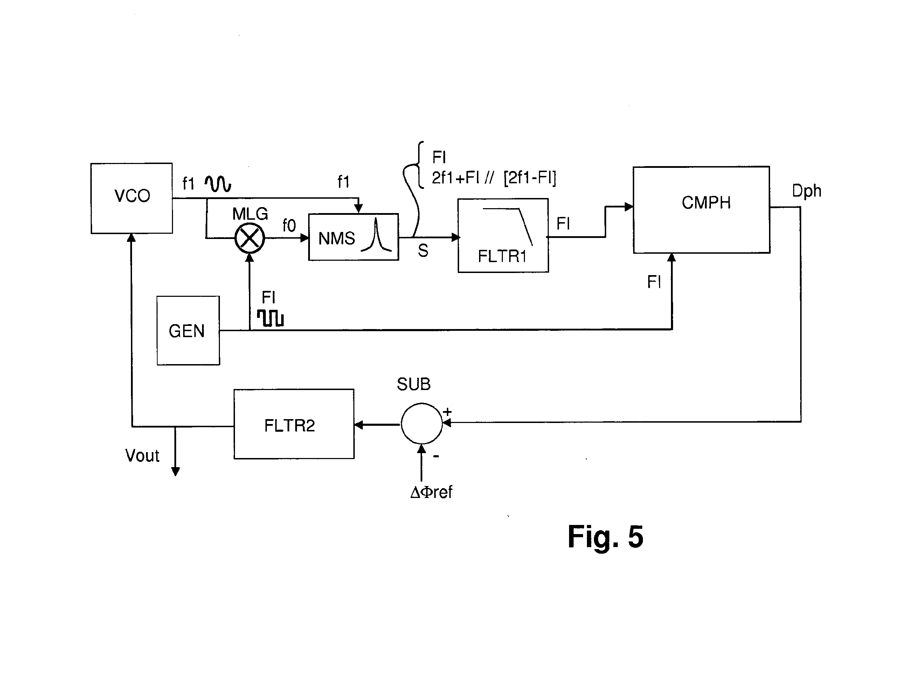

La figure 5 représente une réalisation dans laquelle le générateur de fréquence FI est un simple circuit d'horloge HOR fournissant un signal carré plutôt qu'un signal sinusoïdal à la fréquence FI.

Cela permet de réaliser un générateur numérique particulièrement simple, n'utilisant que des fonctions logiques telles qu'une horloge et des bascules, mais pas de convertisseur numérique-analogique. Si le générateur devait fournir un signal sinusoïdal et était fait sous forme d'un synthétiseur directe de fréquence numérique, il devrait comprendre un tel convertisseur numérique analogique pour réaliser un signal à peu près sinusoïdal à la fréquence synthétisée numériquement.

Si le générateur fournit un signal carré à la fréquence FI, ce signal comporte des harmoniques aux fréquences multiples de FI. Le signal de sortie du mélangeur contient donc des composantes à des fréquences résultant de la combinaison de la fréquence f1 avec ces harmoniques. Mais le résonateur est en lui-même un filtre à bande très étroite qui élimine la plupart de ces harmoniques, de sorte que le signal de sortie n'est presque pas affecté par le fait que le signal du générateur est carré.

Un avantage d'un générateur à sortie carrée, outre le fait qu'il est très simple à réaliser, est le fait qu'il peut fournir très facilement deux composantes en quadrature de phase : il suffit qu'il soit réalisé à partir d'une horloge numérique à fréquence quadruple de la fréquence FI. On verra plus loin qu'il est avantageux de prévoir une comparaison de phase à deux voies en quadrature de phase, et un générateur de fréquence fournissant un signal carré est particulièrement avantageux dans ce cas.

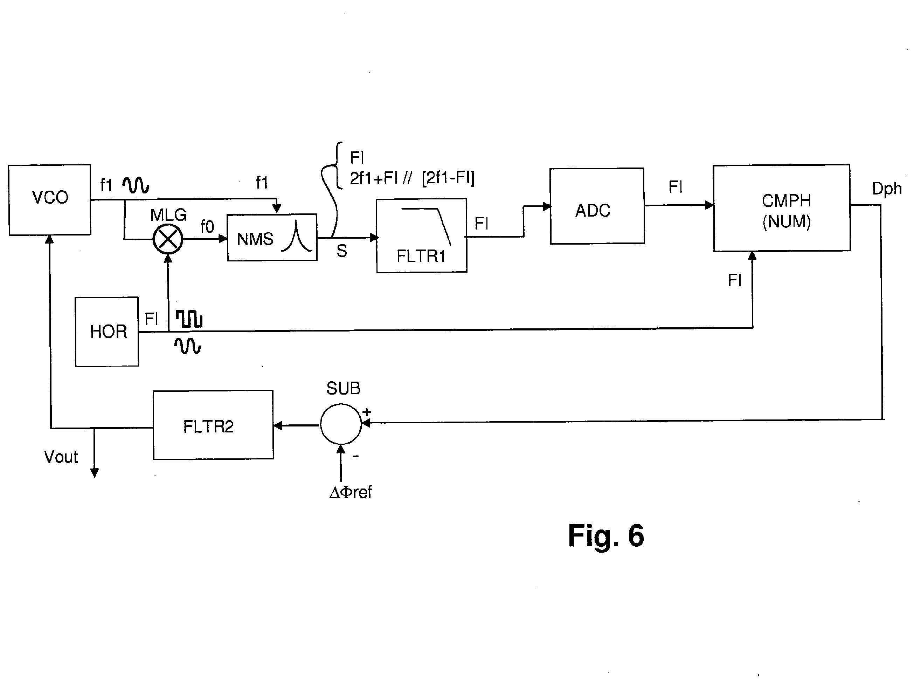

La figure 6 représente une réalisation dans laquelle le comparateur de phase est entièrement numérique. Un convertisseur analogique-numérique ADC est prévu en amont du comparateur, placé en sortie du filtre FLTR1 ; il convertit un signal à fréquence FI et fournit un signal numérique à fréquence FI ayant la phase et la fréquence du signal en sortie du résonateur.

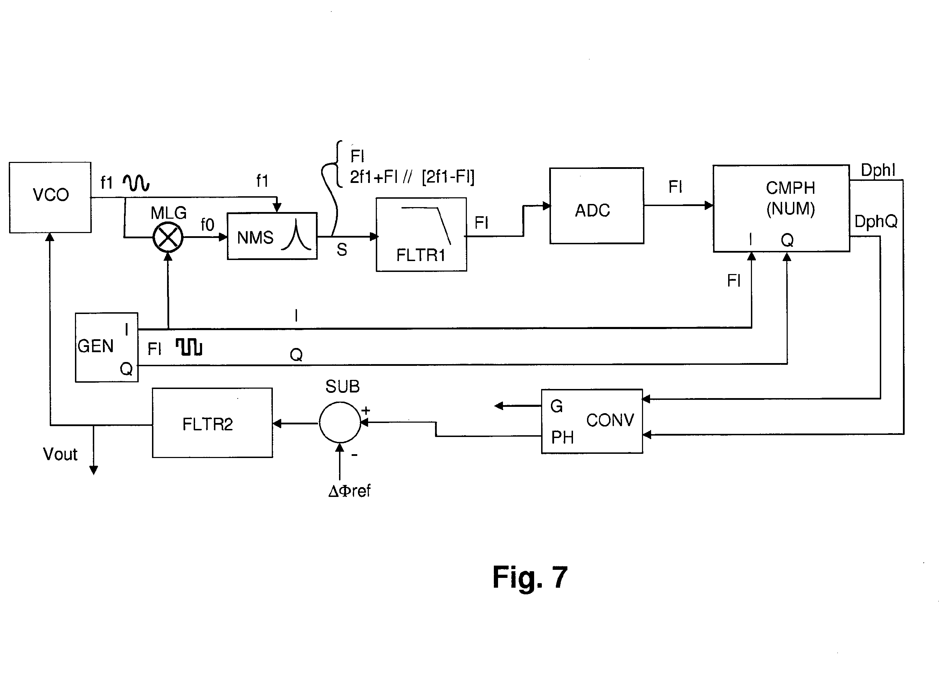

La figure 7 représente une réalisation préférée dans laquelle le générateur GEN fournit deux signaux à fréquence FI en quadrature de phase, et le comparateur de phase CMPH (de préférence numérique) traite ces deux voies pour fournir deux signaux de mesure de déphasage DphI et DphQ. Leur somme quadratique dépend de l'amplitude du signal détecté, et leur rapport représente la phase du signal détecté.

Dans ce cas, le générateur GEN fournit de préférence deux signaux carrés en quadrature de phase au comparateur de phase. S'il fournit des signaux sinusoïdaux au mélangeur MLG, ces signaux sont fournis par exemple après conversion dans un convertisseur numérique-analogique faisant partie du générateur, et les signaux carrés à destination du comparateur de phase sont alors prélevés en amont de ce convertisseur plutôt qu'en aval. Mais si les signaux envoyés au mélangeur MLG et au comparateur de phase sont carrés, alors le générateur peut être un simple circuit logique contrôlé par une horloge à fréquence quadruple de FI.

Les signaux numériques DphI et DphQ représentant le déphasage (mesures en coordonnées cartésiennes), sont convertis en un gain G et un déphasage PH (mesures en coordonnées polaires) par un organe de calcul CONV. Le gain est la somme quadratique des déphasages DphI et DphQ ; la phase est l'arctangente du rapport DphQ/DphI. Le gain G n'est utilisé que pendant la calibration en boucle ouverte servant à déterminer le déphasage à la résonance : c'est en effet le pic de gain qui définit la résonance. En boucle ouverte, la phase PH prend à la résonance la valeur $\Delta\phi$ref qui sera appliquée comme consigne en boucle fermée. En boucle fermée, la phase PH est appliquée au soustracteur SUB.

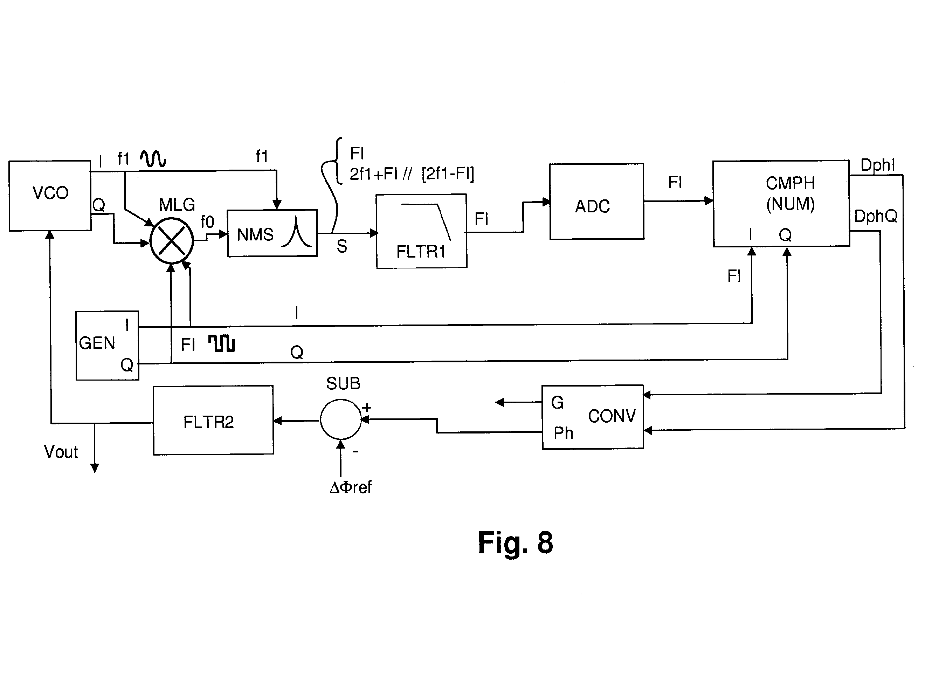

La figure 8 représente une réalisation dans laquelle l'oscillateur à fréquence contrôlée VCO fournit lui aussi deux voies en quadrature de phase. Ceci est possible notamment si l'oscillateur est réalisé par un circuit de synthèse numérique directe de fréquence à fréquence variable comprenant un convertisseur numérique-analogique.

Dans ce cas les deux voies I et Q issues de l'oscillateur VCO, ainsi que les deux voies I et Q issues du générateur GEN peuvent être appliquées au mélangeur MLG. Celui-ci est alors un mélangeur complexe et non un mélangeur simple. Il comporte quatre voies d'entrée et deux sorties. Toutefois, une seule sortie est utilisée en boucle fermée. L'avantage d'un mélangeur complexe, qui mélange à la fois les voies I et Q, est le fait que les sorties peuvent fournir soit la fréquence somme soit la fréquence différence, au lieu que ces deux fréquences soient mélangées dans une même sortie. Cela facilite notamment l'opération de calibration en boucle ouverte, car on sait si on est calé sur la fréquence somme ou sur la fréquence différente. Mais en boucle fermée, on peut reconfigurer le mélangeur complexe en un mélangeur simple permettant d'avoir un bruit de phase plus réduit. La reconfiguration s'effectue par commutation des entrées et sorties.

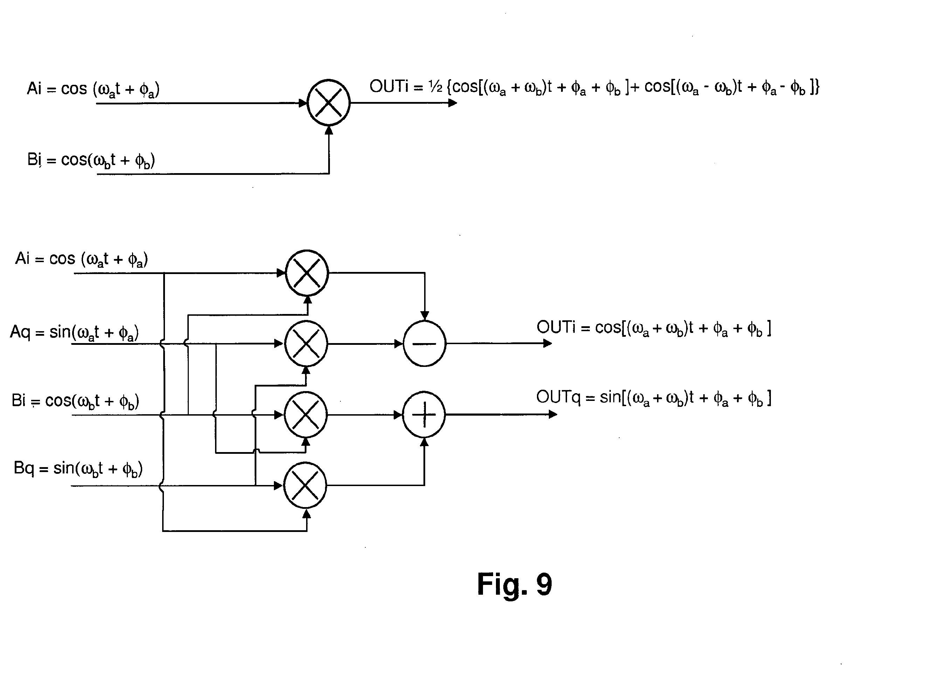

La figure 9 représente le principe d'un mélangeur complexe, comparé à un mélangeur simple. Les équations générales qui régissent le mélange sont les suivantes, dans lesquelles Ai et Bi représentent deux signaux d'entrée de fréquences respectives $\omega_a$ et $\omega_b$ et de phases respectives $\phi_a$ et $\phi_b$, Aq et Bq représentent les signaux correspondants en quadrature de phase avec les premiers, OUTi représente la sortie dans le cas d'un mélangeur simple de Ai et Bi, et OUTi et OUTq représentent les deux sorties en quadrature de phase dans le cas d'un mélangeur complexe. Les amplitudes de signaux d'entrée sont normalisées à 1.

1) <u>Mélangeur simple de Ai et Bi</u> :

Il comprend seulement un multiplieur recevant les signaux Ai et Bi.

$$Ai = \cos(\omega_a t + \phi_a)$$

$$Bi = \sin(\omega_b t + \phi_b)$$

$$OUTi = \tfrac{1}{2} \{\cos[(\omega_a + \omega_b)t + \phi_a + \phi_b] + \cos[(\omega_a - \omega_b)t + \phi_a - \phi_b]\}$$

Les deux composantes à fréquence somme et différence sont présentes simultanément dans la sortie.

2) <u>Mélangeur complexe de Ai, Bi, Ag et Bg</u>

Il comprend quatre multiplieurs pour réaliser les produits AiBi, AqBq, AiBq et AqBi, et deux additionneurs pour réaliser les quantités (AiBi-AqBq) et (AqBi+AiBq).

$$Ai = \cos(\omega_a t + \phi_a)$$

$$Bi = \cos(\omega_b t + \phi_b)$$

$$Aq = \sin(\omega_a t + \phi_a)$$

$$Bq = \sin(\omega_b t + \phi_b)$$

$$OUTi = (AiBi-AqBq) = \cos[(\omega_a + \omega_b)t + \phi_a + \phi_b]$$

$$OUTq = (AqBi+AiBq) = \sin[(\omega_a + \omega_b)t + \phi_a + \phi_b]$$

Seule la fréquence somme ($\omega_a + \omega_b$) apparaît dans les signaux de sortie ; mais on pourrait obtenir seulement la fréquence différence ($\omega_a - \omega_b$) en croisant différemment les liaisons entre multiplieurs et additionneurs.

Le mélangeur complexe peut être reconfiguré en mélangeur simple en n'utilisant pas les additionneurs et en n'utilisant que le premier multiplieur recevant Ai et Bi.

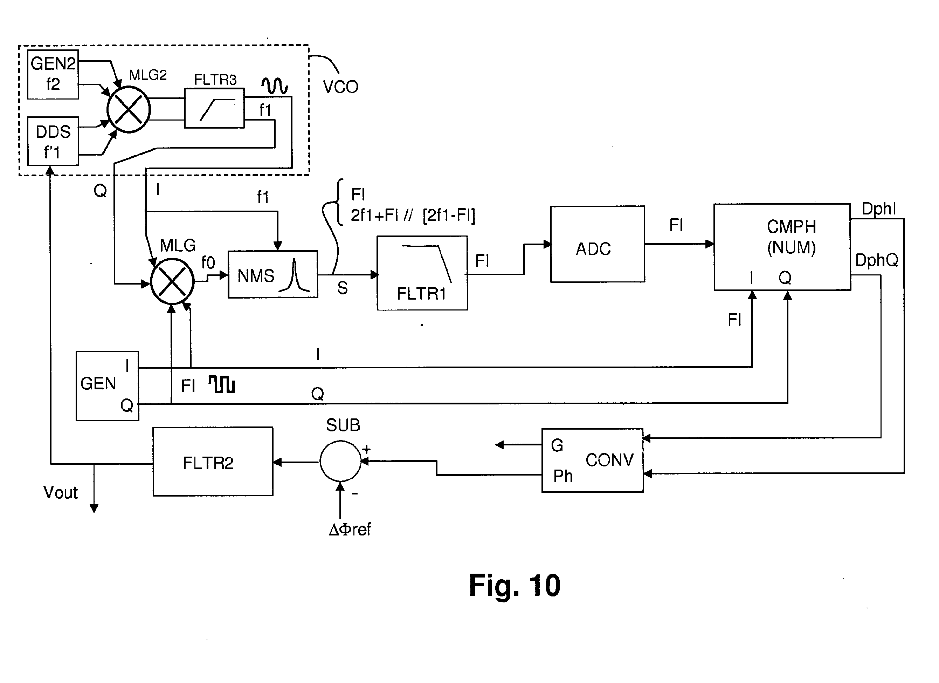

La figure 10 représente une réalisation particulière dans laquelle l'oscillateur à fréquence contrôlée qui produit la fréquence de polarisation f1 est constitué de plusieurs parties : un oscillateur analogique ou numérique à fréquence contrôlée DDS fonctionnant à fréquence plus basse f'1 et commandé par la boucle d'asservissement, un oscillateur GEN2 à fréquence fixe mais paramétrable f2, un mélangeur MLG2 pour mélanger la fréquence f'1 et la fréquence f2 pour produire la fréquence somme et la fréquence différence et un filtre FLTR3 pour éliminer l'une de ces deux fréquences, par exemple f2-f'1, et conserver l'autre f2+f'1 comme fréquence de polarisation f1.

Cela permet de simplifier la réalisation de l'oscillateur commandé par la boucle, en particulier lorsque celui-ci est constitué par un synthétiseur de fréquence numérique directe suivi d'un convertisseur numérique-analogique ; en effet, on peut alors faire travailler ce convertisseur à une fréquence f'1 assez basse et sur une plage de variation limitée. Cela permet aussi de travailler avec des résonateurs de fréquences variées, en ajustant la valeur de la fréquence de décalage f2 en fonction du type de résonateur utilisé, sans agir sur la fréquence intermédiaire FI.

L'oscillateur à fréquence f'1 commandé par la boucle d'asservissement peut être un synthétiseur numérique direct de fréquence fournissant deux signaux en quadrature de phase. L'oscillateur à fréquence fixe f2 paramétrable peut être un simple circuit d'horloge fournissant deux signaux carrés en quadrature de phase (ce qui est particulièrement simple à réaliser), ou un synthétiseur numérique plus complexe mais fournissant des signaux sinusoïdaux, donc de meilleure pureté spectrale.

Le réglage de la fréquence f2 est fait en fonction de la gamme de résonateurs utilisée. En effet, en supposant que la fréquence intermédiaire FI est fixe, la gamme de fréquence de résonance f0 varie en fonction des caractéristiques du résonateur ; la gamme de fréquences de polarisation f1 varie de la même manière ; mais la plage de variation de f'1 peut être très limitée si on choisit la fréquence f2 de manière appropriée en tenant compte de la gamme de fréquences de résonance dans laquelle se situe le résonateur considéré ; on peut donc se contenter d'un oscillateur à fréquence contrôlée simple n'ayant pas besoin d'une large gamme de variation de sa fréquence pour assurer l'asservissement.

## Revendications

1. Circuit de mesure de la fréquence d'oscillation d'un résonateur (NMS) du type comportant une entrée d'excitation pour recevoir un signal d'actionnement à une fréquence proche de la fréquence de résonance du résonateur et une entrée de polarisation pour recevoir un signal de polarisation comprenant une composante alternative à une fréquence de polarisation f1, le circuit comportant une boucle d'asservissement de phase comprenant le résonateur (NMS), un oscillateur à fréquence contrôlée (VCO), et un comparateur de phase (CMPH), le circuit de mesure étant **caractérisé en ce que** l'oscillateur à fréquence contrôlée produit la fréquence de polarisation f1 et est relié à l'entrée de polarisation du résonateur pour lui appliquer cette fréquence f1, et **en ce qu'**il comprend en outre un générateur de fréquence (GEN) fournissant une fréquence intermédiaire fixe FI, un mélangeur (MLG) pour mélanger la fréquence intermédiaire et la fréquence de polarisation f1 et fournir une fréquence d'excitation f0 somme ou différence de f1 et FI et pour appliquer cette fréquence d'excitation f0 à l'entrée d'excitation en tant que signal d'actionnement, le comparateur de phase recevant la fréquence intermédiaire FI du générateur et un signal de sortie filtré issu du résonateur, et fournissant un signal d'asservissement (Dph) servant à commander la fréquence f1 de l'oscillateur dans un sens tendant à maintenir la fréquence d'excitation en sortie du mélangeur (MLG) à la valeur de la fréquence de résonance du résonateur.

2. Circuit de mesure selon la revendication 1, **caractérisé en ce que** la fréquence intermédiaire FI a une valeur supérieure à la largeur de bande du résonateur.

3. Circuit de mesure selon l'une des revendications 1 et 2, **caractérisé en ce que** la sortie du mélangeur est appliquée directement à l'entrée d'excitation du résonateur, sans filtrage passe haut préalable.

4. Circuit de mesure selon l'une des revendications 1 à 3, **caractérisé en ce que** le générateur de fréquence qui produit la fréquence intermédiaire FI fournit un signal sinusoïdal ou un signal carré.

5. Circuit de mesure selon la revendication 4, **caractérisé en ce que** le générateur est un circuit d'horloge fournissant un signal carré à la fréquence FI.

6. Circuit de mesure selon l'une des revendications 1 à 5, **caractérisé en ce que** le générateur de fréquence fournit deux signaux en quadrature de phase.

7. Circuit de mesure selon la revendication 6, **caractérisé en ce que** l'oscillateur à fréquence contrôlée fournit deux signaux en quadrature de phase.

8. Circuit de mesure selon la revendication 7, **caractérisé en ce que** le mélangeur est un mélangeur complexe recevant les signaux en quadrature de phase de l'oscillateur à fréquence contrôlée ainsi que ceux du générateur de fréquence et produisant sur une sortie une fréquence somme ou différence des fréquences reçues.

9. Circuit de mesure selon la revendication 8, **caractérisé en ce que** le mélangeur complexe est utilisé en mélangeur complexe dans une phase de calibration en boucle ouverte et en mélangeur simple, fournissant sur sa sortie à la fois une fréquence somme et une fréquence différence, dans une phase d'utilisation en boucle fermée.

10. Circuit de mesure selon l'une des revendications 1 à 9, **caractérisé en ce que** l'oscillateur à fréquence contrôlée comprend des moyens analogiques ou numériques pour établir une fréquence f'1 variable sous contrôle de la boucle d'asservissement de phase, et un mélangeur pour mélanger cette fréquence f'1 à une fréquence fixe f2 et ainsi produire la fréquence de polarisation variable f1.

**Patentansprüche**

1. Schaltung zum Messen der Oszillationsfrequenz eines Resonators (NMS) des Typs, der einen Anregungseingang zum Empfangen eines Betätigungssignals auf einer Frequenz nahe der Resonanzfrequenz des Resonators und einen Polarisationseingang zum Empfangen eines Polarisationssignals umfasst, umfassend eine alternative Komponente auf einer Polarisationsfrequenz f1, wobei die Schaltung einen Phasenregelkreis umfasst, der den Resonator (NMS), einen Oszillator mit gesteuerter Frequenz (VCO) und einen Phasenkomparator (CMPH) umfasst, wobei die Messschaltung **dadurch gekennzeichnet ist, dass** der Oszillator mit gesteuerter Frequenz die Polarisationsfrequenz f1 erzeugt und mit dem Polarisationseingang des Resonators verbunden ist, um diese Frequenz f1 darauf anzuwenden, und dadurch, dass sie ferner Folgendes umfasst: einen Frequenzgenerator (GEN), der eine feste Zwischenfrequenz FI liefert, einen Mixer (MLG) zum Mischen der Zwischenfrequenz und der Polarisationsfrequenz f1 und zum Bereitstellen einer Anregungsfrequenz f0, die die Summe oder Differenz von f1 und FI ist, und zum Anlegen dieser Anregungsfrequenz f0 an den Anregungseingang als Betätigungssignal, wobei der Phasenkomparator die Zwischenfrequenz FI des Generators und ein filtriertes Ausgangssignal von dem Resonator empfängt und ein Regelsignal (Dph) zum Steuern der Frequenz f1 des Oszillators in einer Richtung liefert, die dazu neigt, die Anregungsfrequenz am Ausgang des Mischers (MLG) auf dem Wert der Resonanzfrequenz des Resonators zu halten.

2. Messschaltung nach Anspruch 1, **dadurch gekennzeichnet, dass** die Zwischenfrequenz FI einen Wert hat, der größer ist als die Bandbreite des Resonators.

3. Messschaltung nach einem der Ansprüche 1 und 2, **dadurch gekennzeichnet, dass** der Ausgang des Mixers direkt an den Anregungseingang des Resonators, ohne vorherige Hochpassfilterung, angelegt wird.

4. Messschaltung nach einem der Ansprüche 1 bis 3, **dadurch gekennzeichnet, dass** der Frequenzgenerator, der die Zwischenfrequenz FI erzeugt, ein sinusförmiges Signal oder ein rechteckförmiges Signal liefert.

5. Messschaltung nach Anspruch 4, **dadurch gekennzeichnet, dass** der Generator eine Taktgeberschaltung ist, die ein rechteckförmiges Signal mit der Frequenz FI liefert.

6. Messschaltung nach einem der Ansprüche 1 bis 5, **dadurch gekennzeichnet, dass** der Frequenzgenerator zwei Signale in Phasenquadratur liefert.

7. Messschaltung nach Anspruch 6, **dadurch gekennzeichnet, dass** der Oszillator mit gesteuerter Frequenz zwei Signale in Phasenquadratur liefert.

8. Messschaltung nach Anspruch 7, **dadurch gekennzeichnet, dass** der Mixer ein komplexer Mixer ist, der die Phasenquadratursignale des Oszillators mit gesteuerter Frequenz sowie die des Frequenzgenerators empfängt und an einem Ausgang eine Summen- oder Differenzfrequenz der empfangenen Frequenzen erzeugt.

9. Messschaltung nach Anspruch 8, **dadurch gekennzeichnet, dass** der komplexe Mixer als komplexer Mixer in einer Kalibrationsphase mit offenem Regelkreis und als einfacher Mixer benutzt wird, der an seinem Ausgang gleichzeitig eine Summenfrequenz und eine Differenzfrequenz in einer Nutzungsphase im geschlossenen Regelkreis liefert.

10. Messschaltung nach einem der Ansprüche 1 bis 9, **dadurch gekennzeichnet, dass** der Oszillator mit gesteuerter Frequenz analoge oder digitale Mittel zum Festlegen einer Frequenz f'1, die unter der Steuerung des Phasenregelkreises variabel ist, und einen Mixer zum Mischen dieser Frequenz f'1 mit einer festen Frequenz f2 und somit zum Erzeugen der variablen Polarisationsfrequenz f1 umfasst.

**Claims**

1. Circuit for measuring the oscillation frequency of a resonator (NMS) of the type including an excitation input for receiving an actuation signal at a frequency close to the resonant frequency of the resonator and a polarization input for receiving a polarization signal comprising an AC component at a polarization frequency f1, the circuit including a phase-locked loop comprising the resonator (NMS), a frequency-controlled oscillator (VCO), and a phase comparator (CMPH), the measurement circuit being **characterized in that** the frequency-controlled oscillator produces the polarization frequency f1 and is linked to the polarization input of the resonator for applying this frequency f1 to it, and **in that** it furthermore comprises a frequency generator (GEN) supplying a fixed intermediate frequency FI, a mixer (MLG) for mixing the intermediate frequency and the polarization frequency f1 and for supplying an excitation frequency f0 that is the sum or difference of f1 and FI and for applying this excitation frequency f0 to the excitation input as actuation signal, the phase comparator receiving the intermediate frequency FI from the generator and a filtered output signal coming from the resonator, and supplying a locking signal (Dph) serving to control the frequency f1 of the oscillator in a direction tending to maintain the excitation frequency at the output of the mixer (MLG) at the value of the resonant frequency of the resonator.

2. Measurement circuit according to Claim 1, **characterized in that** the intermediate frequency FI has a value greater than the bandwidth of the resonator.

3. Measurement circuit according to one of Claims 1 or 2, **characterized in that** the output of the mixer is applied directly to the excitation input of the resonator, without prior high-pass filtering.

4. Measurement circuit according to one of Claims 1 to 3, **characterized in that** the frequency generator that produces the intermediate frequency FI supplies a sinusoidal signal or a square signal.

5. Measurement circuit according to Claim 4, **characterized in that** the generator is a clock circuit supplying a square signal at the frequency FI.

6. Measurement circuit according to one of Claims 1 to 5, **characterized in that** the frequency generator supplies two signals in phase quadrature.

7. Measurement circuit according to Claim 6, **characterized in that** the frequency-controlled oscillator supplies two signals in phase quadrature.

8. Measurement circuit according to Claim 7, **characterized in that** the mixer is a complex mixer receiving the phase quadrature signals of the frequency-controlled oscillator as well as those of the frequency generator and producing on an output a sum or difference frequency of the received frequencies.

9. Measurement circuit according to Claim 8, **characterized in that** the complex mixer is used as a complex mixer in an open-loop calibration phase and as a simple mixer, supplying at once a sum frequency and a difference frequency on its output, in a closed-loop use phase.

10. Measurement circuit according to one of Claims 1 to 9, **characterized in that** the frequency-controlled oscillator comprises analogue or digital means for establishing a variable frequency f'1 under the control of the phase-locked loop, and a mixer for mixing this frequency f'1 with a fixed frequency f2 and thus producing the variable polarization frequency f1.

Fig. 1

Fig. 2

**Fig. 3**

**Fig. 4**

EP 2 793 399 B1

Fig. 5

Fig. 6

**Fig. 7**

EP 2 793 399 B1

**Fig. 8**

EP 2 793 399 B1

$Ai = \cos(\omega_a t + \phi_a)$

$Bi = \cos(\omega_b t + \phi_b)$

$OUTi = \tfrac{1}{2}\{\cos[(\omega_a + \omega_b)t + \phi_a + \phi_b] + \cos[(\omega_a - \omega_b)t + \phi_a - \phi_b]\}$

$Ai = \cos(\omega_a t + \phi_a)$

$Aq = \sin(\omega_a t + \phi_a)$

$Bi = \cos(\omega_b t + \phi_b)$

$Bq = \sin(\omega_b t + \phi_b)$

$OUTi = \cos[(\omega_a + \omega_b)t + \phi_a + \phi_b]$

$OUTq = \sin[(\omega_a + \omega_b)t + \phi_a + \phi_b]$

**Fig. 9**

Fig. 10

EP 2 793 399 B1

**EP 2 793 399 B1**

## RÉFÉRENCES CITÉES DANS LA DESCRIPTION

**Documents brevets cités dans la description**

- WO 2005081929 A
- US 2011254599 A1
- FR 2964651